# FASCICULE DE BREVET EUROPEEN

(11) **EP 0 424 241 B1**
(45) Date de publication et mention de la délivrance du brevet: **23.11.1994**
(21) Numéro de dépôt: 90402889.1
(22) Date de dépôt: 16.10.1990
(51) Int. Cl.: H01L 27/148

(54) **Détecteurs d'images à forte capacité de stockage par pixel**
Bilddetektor mit grosser Speicherkapazität pro Pixel
Image detector with large storage capacity for each pixel

(30) Priorité: 20.10.1989 FR 8913748
(43) Date de publication de la demande: 24.04.1991
(73) Titulaire: THOMSON-CSF SEMICONDUCTEURS SPECIFIQUES, 75008 Paris (FR)
(72) Inventeur: Cazaux, Yvon, F-92045 Paris la Défense (FR); Boucharlat, Gilles, F-92045 Paris la Défense (FR)
(74) Mandataire: Guérin, Michel

(56) Documents cités:
- US-A- 4 870 494
- SPIE OPTICAL SENSORS AND ELECTRONIC PHOTOGRAPHY, vol. 1071, 1989, pages 153-169; J. JANESICK et al.: "Charge-coupled device pinning technologies"
- PATENT ABSTRACTS OF JAPAN, vol. 6, no. 9 (E-90)[887], 20 janvier 1982 & JP-A-56 131 976
- PATENT ABSTRACTS OF JAPAN, vol. 6, no. 16 (E-92)[894], 20 janvier 1982 & JP-A-56 136 086

## Description

La présente invention concerne les dispositifs semiconducteurs photosensibles à transfert de charges, destinés à constituer des détecteurs d'images et comportant au moins une ligne de points photodétecteurs. L'invention concerne particulièrement une structure nouvelle des points photodétecteurs, structure qui permet d'améliorer de manière importante la capacité de stockage de ces points photodétecteurs.

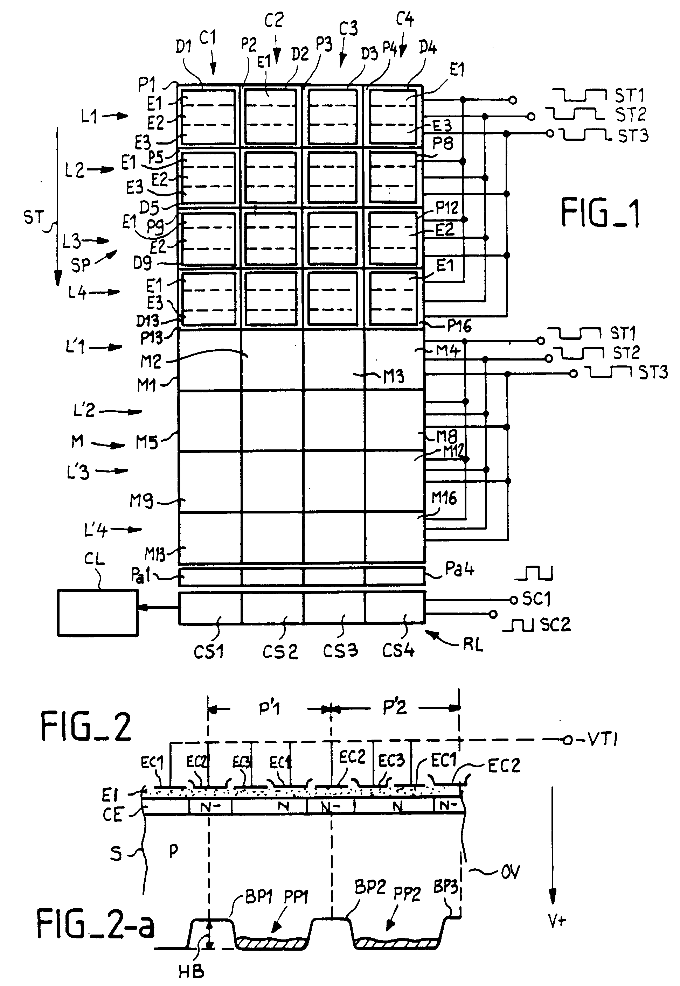

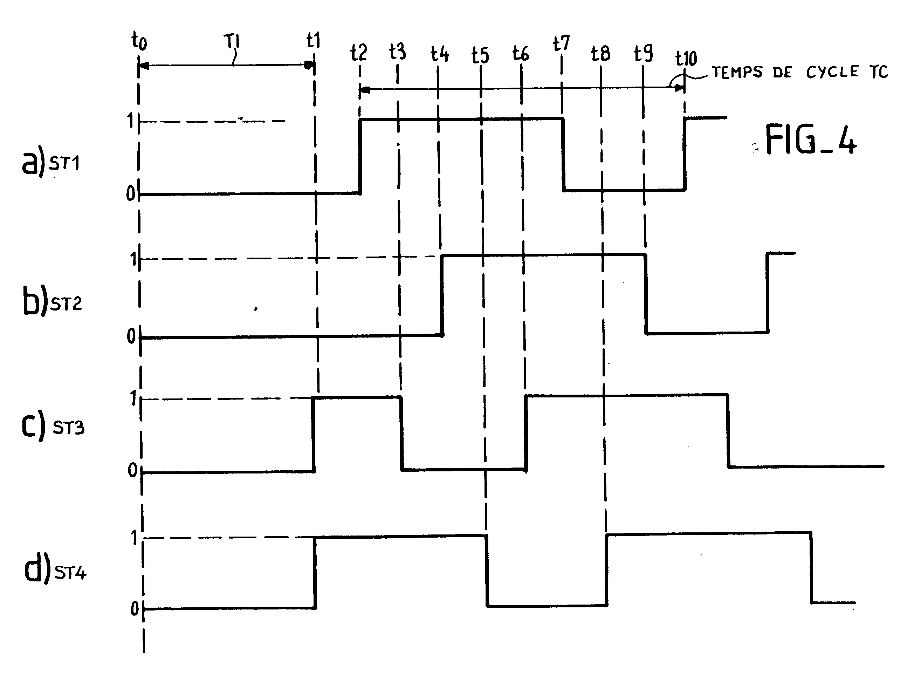

La figure 1 montre schématiquement une architecture classique d'un dispositif à transfert de charges (en anglais "Charges Coupled Devices" ou en abrégé CCD) organisée pour constituer un détecteur d'images surfacique. Le détecteur d'images comprend une surface photosensible SP, partagée en une pluralité de points élémentaires d'image ou pixels P1 à P16 comportant chacun un détecteur élémentaire D1 à D16 ou zone élémentaire photosensible. Les détecteurs élémentaires sont disposés en lignes et en colonnes, et dans l'exemple non limitatif de la figure 1 et pour simplifier cette dernière, seulement quatre lignes L1 à L4 et quatre colonnes C1 à C4 de détecteurs élémentaires ont été représentées, mais bien entendu le détecteur d'images peut comporter un nombre plus important de lignes et de colonnes où même un nombre plus faible.

Suivant un arrangement conventionnel, la surface photosensible SP est prolongée dans le sens des colonnes C1 à C4 par une mémoire à transfert de charges M formant quatre lignes supplémentaires L′1 à L′4. La mémoire M est elle-même suivie de manière classique, par un registre de lecture RL à transfert de charges. La mémoire M est reliée de manière conventionnelle au registre de lecture par l'intermédiaire de portes analogiques Pa1 à Pa4. La mémoire M est constituée d'une même manière que la surface sensible SP, c'est-à-dire qu'elle est également photosensible et, pour éviter qu'elle ne produise des charges sous l'effet d'un éclairement auquel peut être exposée la surface photosensible SP, toute la zone correspondant à la mémoire M (mais également la zone correspondant aux portes analogiques et au registre de lecture), est abritée de façon classique par un écran opaque (non représenté) (en aluminium par exemple) au rayonnement utile auquel est exposée la surface photosensible SP.

Le fonctionnement d'un tel dispositif est bien connu :
- la surface photosensible SP étant exposée à un rayonnement utile (lumière notamment) pendant un temps appelé temps d'intégration TI, des charges sont engendrées et stockées au niveau de chaque pixel. A la fin du temps d'intégration TI, pour chaque pixel, les charges stockées en ce point sont transférées dans une case mémoire M1 à M16, chaque case mémoire correspondant à un pixel P1 à P16 donné.

Ce transfert est accompli dans le sens des colonnes C1 à C4 : en prenant l'exemple de la première colonne C1 par exemple, les charges contenues au treizième pixel P13 sont transférées à la treizième case mémoire M13 en passant successivement par la première, la cinquième et la neuvième cases mémoires, pendant que d'une manière semblable les charges initialement contenues aux premier, cinquième et neuvième pixels P1, P5, P9 sont transférées respectivement à la première, cinquième et neuvième cases mémoires M1, M5 et M9. Dans le même temps, des opérations semblables sont réalisées au niveau des colonnes C2, C3, C4. Ceci est obtenu de manière classique en appliquant des signaux de transfert ST1, ST2, ST3 aux points élémentaires P1 à P16 ainsi qu'aux zones mémoires M1 à M16. Ces signaux de transfert ont des phases différentes de manière à engendrer des barrières et des puits de potentiel qui permettent de transférer les charges suivant les colonnes C1 à C4, c'est-à-dire suivant un sens de transfert ST qui doit conduire ces charges depuis la surface photosensible SP jusque dans une case CS1 à CS4 du registre de lecture RL. Le mode de transfert peut s'effectuer en biphase, ou en trois phases, quatre phases ou davantage : dans l'exemple représenté à la figure 1, ce transfert est effectué en mode trois phases, c'est-à-dire que chaque point détecteur P1 à P16 comporte trois électrodes E1, E2, E3 qui se succèdent dans le sens des colonnes C1 à C4, et auxquelles sont appliqués les signaux de transfert ST1, ST2, ST3 de phases différentes.
- Les charges ayant été transférées jusque dans une zone mémoire M1 à M16, une nouvelle période d'intégration T1 débute et de nouvelles charges peuvent être engendrées et stockées au niveau de chacun des points élémentaires P1 à P16. Durant cette nouvelle période d'intégration T1, toutes les charges stockées dans les zones mémoires M1 à M16 sont transférées ligne par ligne dans les cases mémoires CS1 à CS4 du registre de lecture RL : à cet effet les signaux de transfert ST1, ST2, ST3 sont appliqués uniquement aux zones mémoires M1 à M16 en synchronisme avec des signaux de commande de décalage SC1, SC2 qui sont appliqués au registre de lecture RL : sous l'action des signaux de transfert, les charges stockées dans les treizième, quatorzième, quinzième et seizième zones mémoires (zones mémoires qui forment une ligne L′4 la plus proche du registre de lecture RL) sont transférées respectivement dans les cases CS1, CS2, CS3, CS4 du registre de lecture, pendant que les charges contenues dans les autres zones mémoires sont transférées dans des zones mémoires de la ligne suivante plus proche du registre de lecture RL. Les signaux de commande de décalage SC1, SC2 sont ensuite appliqués au registre de lecture qui transfert les charges contenues dans les cases CS1 à CS4 à un circuit de lecture CL. La registre de lecture étant vidé, les opérations précédentes sont renouvelées c'est-à-dire que les charges contenues dans les zones mémoires de la ligne la plus proche du registre de lecture sont transférées dans ce dernier ; toutes les charges qui ont accumulées lors de la précédente période d'intégration TI doivent être évacuées des zones mémoires M1 à M16 quand s'achève la dernière période d'intégration TI.

La structure et le fonctionnement résumés ci-dessus sont bien connus et sont largement utilisés. Cependant, on cherche à affiner les caractéristiques d'une manière générale et, dans certaines applications, on cherche notamment à augmenter la capacité de stockage des charges au niveau de chaque pixel, ainsi qu'à réduire au maximum le courant d'obscurité par pixel de ces détecteurs d'images CCD.

Pour réduire le courant d'obscurité des détecteurs d'images CCD, il est connu de les refroidir. Mais cette méthode est lourde à mettre en oeuvre.

Une autre méthode, qui permet de diminuer fortement le courant d'obscurité des détecteurs d'images CCD, consiste à les faire fonctionner suivant le mode de fonctionnement appelé "mode MPP" (de l'anglais Multi-Pinned Phase).

Le fonctionnement en mode MPP s'applique particulièrement au cas des dispositifs CCD du type à canal enterré. Dans ce mode de fonctionnement, on inverse la polarité du canal enterré à l'interface substrat-couche isolante c'est-à-dire généralement l'interface silicium-oxyde de silicium. Lors de l'inversion à l'interface Si-SiO₂, il y a accumulation de trous qui neutralisent la génération thermique de charges dans cette région. Le courant d'obscurité étant essentiellement un courant produit dans la région de l'interface, il est diminué de façon très importante dans ce type de fonctionnement. On trouve une explication du fonctionnement en mode MPP dans l'article "Charges-Coupled Device Pinning Technologies" de James Janesick, Tom Elliott, George Fraschetti, Stewart Collins ; publié dans la revue SPIE Vol. 1071 Optical Sensors and Electronic Photography (1989)/153.

La figure 2 illustre à titre d'exemple une structure à trois phases c'est-à-dire à trois signaux de transfert, de phases différentes, et illustre les potentiels à appliquer pour fonctionner en mode MPP. La figure 2a est à lire avec la figure 2, elle illustre des profils de potentiels formant des puits de potentiels destinés à stocker des charges engendrées pendant la période d'intégration TI ; conformément à l'habitude en matière de dispositif à transfert de charges, les potentiels positifs vont en croissant vers le bas.

On a montré sur la figure 2 deux pixels P′1, P′2 montrés par une vue en coupe qui, par rapport à la figure 1, peut correspondre par exemple à une vue en coupe dans le sens des colonnes C1 à C4 qui montrerait deux pixels consécutifs tels que les pixels P1, P5. Dans l'exemple, les pixels P′1, P′2 sont formés sur un substrat semiconducteur S de silicium par exemple, dopé de type P. Le substrat S est recouvert d'une couche électriquement isolante EI en SiO₂. La structure MPP décrite étant du type à trois phases, la couche électriquement isolante EI porte des électrodes EC1, EC2, EC3 au nombre de trois par pixel ; ces trois électrodes sont destinées à recevoir des signaux de transfert (non représentés) de phases différentes. Sous la couche isolante EI, une couche dopée de type N est destinée de manière conventionnelle, à constituer un canal enterré CE favorisant le transfert des charges.

En mode MPP, durant la période d'intégration TI précédemment mentionnée, toutes les électrodes d'un pixel sont portées à un potentiel négatif -VTI (généralement de l'ordre de -10 volts) par rapport au substrat. Toutes les électrodes EC1 à EC3 étant à un même potentiel négatif, durant la période d'intégration TI, des différences de dopage ont été introduites dans le canal enterré CE de manière que dans le substrat S, deux pixels voisins soient séparés par une barrière de potentiel BP1, BP2, BP3, un puits de potentiel de stockage des charges PP1, PP2 pour chaque pixel étant ainsi formé. La hauteur HB représente la différence entre les puits de potentiel et les barrières de potentiel et symbolise la quantité de charges qui peut être stockée par puits de potentiel c'est-à-dire par pixel.

Comme il a été déjà mentionné plus haut, le mode de fonctionnement MPP est particulièrement intéressant en ce qu'il permet de réduire de manière considérable le courant d'obscurité Io produit par chaque pixel. Ainsi par exemple dans le cas d'un fonctionnement conventionnel, appelé "fonctionnement en multiphases", le courant d'obscurité Io est de l'ordre de 700.10⁻¹² ampère/cm² à la température ambiante, alors que dans le mode de fonctionnement MPP, le courant d'obscurité Io passe à 25.10⁻¹² ampère/cm² à une même température ambiante.

Mais l'inconvénient du mode MPP réside dans le fait qu'il réduit considérablement la capacité de stockage de charges du pixel, et par conséquent il réduit la dynamique d'utilisation du détecteur d'images vers les forts niveaux d'éclairement.

L'invention a pour but d'apporter une solution à ce problème de la dynamique d'utilisation des détecteurs d'images CCD vers les forts niveaux d'éclairement. Elle s'applique en particulier (mais non exclusivement) aux détecteurs d'images CCD fonctionnant suivant le mode MPP ci-dessus décrit.

Il est à noter que l'invention s'applique dans le cas de capteurs CCD qui comportent un espace non photosensible entre les lignes de pixels ou même entre les colonnes de ces derniers (dans le cadre par exemple d'application du type spectro-radiomètre).

L'invention telle que définie dans la revendication 1 concerne un dispositif photosensible à transfert de charges comportant une pluralité une zone photosensible ou pixels, chaque pixel comportant une zone photosensible élémentaire sous laquelle est formé un puits de potentiel destiné au stockage de charges engendrées par l'exposition de la zone photosensible élémentaire à un rayonnement utile, et dont la surface du puits de potentiel de stockage est plus grande que la surface de la zone photosensible élémentaire, les deux surfaces étant considérées dans des plans sensiblement parallèles. Des exemples de réalisation particuliers sont définis dans les revendications dépendantes.

Les caractéristiques et avantages de l'invention ressortiront mieux à la description qui suit, donnés à titre d'exemple non limitatif, en référence aux dessins annexés dans lesquels :
- la figure 1 déjà décrite montre l'organisation générale d'un détecteur d'images CCD de type connu ;
- les figures 2 et 2a déjà décrites illustrent la structure et le fonctionnement de détecteurs photosensibles fonctionnant suivant le mode MPP ;
- la figure 3 est une vue en coupe qui montre schématiquement la structure d'un dispositif détecteur d'images conforme à l'invention ;
- les figures 3a, 3b, 3c montrent des profils de potentiels en relation avec la structure de la figure 3 ;
- la figure 4 illustre des signaux à appliquer à la structure montrée à la figure 3.

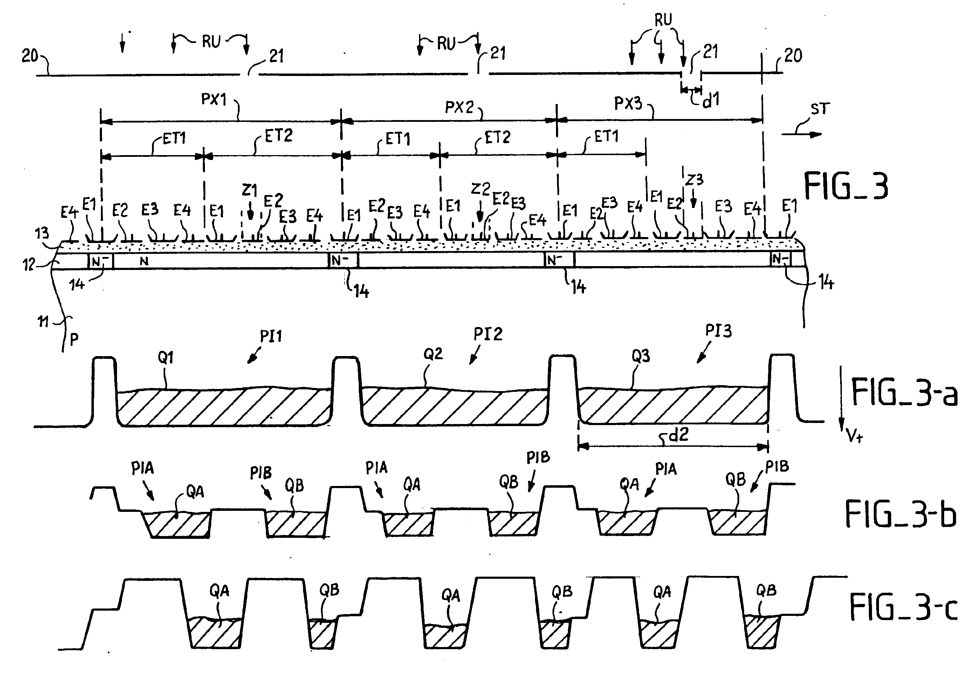

La figure 3 est une vue schématique, en coupe, de plusieurs points élémentaires d'image ou pixels consécutifs d'un détecteur d'images de type à transfert de charges conforme à l'invention. Ces pixels PX1, PX2, PX3 sont disposés dans le sens de colonnes telles que les colonnes C1 à C4 montrées à la figure 1, c'est-à-dire dans le sens du transfert ST des charges vers un registre de lecture (non représenté).

Pour simplifier la figure 3 et la description, le détecteur d'images ou dispositif photosensible 10 de l'invention est représenté par seulement les trois pixels PX1 à PX3. Le dispositif photosensible comprend un substrat 11 en silicium par exemple dopé de type P. Le substrat 11 comporte, à proximité de sa surface, une couche 12 dopée du type N, destinée à constituer un canal enterré. Au-dessus du canal enterré 12, une couche électriquement isolante 13, en SiO₂ par exemple, porte une succession d'électrodes formant une succession d'étages de transfert ET1, ET2. Dans l'exemple non limitatif de la description, chaque étage ET1, ET2 comprend quatre électrodes E1, E2, E3, E4 destinées à recevoir des signaux de transfert (non représentés) de phases différentes, le mode de transfert des charges étant en quatre phases.

Chaque pixel PX1, PX2, PX3 comporte une zone élémentaire photosensible Z1, Z2, Z3 et un puits de potentiel PI1, PI2, PI3 (figure 3a) destiné à stocker des charges produites par le pixel lors de la période d'intégration.

Selon une caractéristique de l'invention, les puits de potentiel de stockage PI1, PI2, PI3 ont une surface plus grande que la surface des zones élémentaires photosensibles Z1, Z2, Z3, d'où il résulte par rapport à l'art antérieur, une augmentation de la capacité de stockage de charges au niveau de chaque pixel.

A cette fin, dans l'exemple non limitatif de la description, chaque pixel comporte deux étages de transfert consécutifs pouvant former un unique puits de potentiel, alors que la surface de la zone élémentaire photosensible du même pixel a, dans cet exemple, une surface limitée à celle d'une seule électrode, à savoir l'électrode E2 de l'étage ET2 dans l'exemple non limitatif décrit.

Bien entendu chaque pixel PX1 à PX3 pourrait comporter plus que deux étages ET1, ET2, l'important étant que la surface du puits de potentiel de stockage PI1, PI2, PI3 d'un pixel soit supérieure à la surface de la zone photosensible élémentaire Z1 à Z3 du même pixel, ces deux surfaces étant bien entendu considérées dans des plans sensiblement parallèles. En outre, à deux ou plusieurs étages de transfert pour un pixel, le résultat de l'invention peut également être obtenu avec un fonctionnement en mode biphase, ou à trois phases, cinq phases ou plus.

Dans l'exemple non limitatif décrit où toutes les électrodes E1 à E4 sont transparentes au rayonnement utile (représenté par des flèches RU) de telle manière que l'ensemble de leur surface est photosensible, un écran 20 opaque au rayonnement utile a été interposé entre ce dernier et l'ensemble des électrodes, à l'exception d'une électrode par pixel qui représente la zone photosensible élémentaire du pixel, l'électrode E2 dans l'exemple non limitatif décrit. L'écran comporte à cet effet des ouvertures 21 dont les dimensions sont très inférieures aux dimensions des puits de potentiels PI1 à PI3 et dont la surface détermine la surface des zones photosensibles.

On indique ci-après à titre d'exemple non limitatif, des ordres de grandeur des dimensions de zones élémentaires photosensibles Z1 à Z3 et des puits de potentiels de stockage PI1 à PI3 : en supposant par exemple que dans le sens des lignes de pixels c'est-à-dire dans un sens perpendiculaire au plan de la figure, ces puits et ces zones aient une même dimension, dans un sens parallèle au plan de la figure les zones élémentaires photosensibles Z1 à Z3 peuvent avoir une dimension d1 de l'ordre de 20 micromètres et les puits de potentiel PI1 à PI3 peuvent avoir une dimension d2 de l'ordre de 150 micromètres.

Dans le cas d'un fonctionnement en mode MPP, fonctionnement dans lequel toutes les électrodes E1 à E4 de tous les étages ET1, ET2, sont portées à un potentiel négatif par rapport au substrat 11 durant la période d'intégration TI, les puits de potentiel PI1 à PI3 sont formés entre des barrières de potentiel BP1, BP2, BP3, BP4 (voir la figure 2a) obtenues par des différences localisées de dopage du matériau semiconducteur dans le canal enterré 12, à savoir par des zones 14 dopées N- ; ces zones 14 étant ainsi du même type de conductivité que le canal enterré 12 lequel est dopé de type N, mais sont moins dopées que ce dernier.

Selon une caractéristique de l'invention, les zones 14 ne sont pas réalisées obligatoirement à raison d'une par étage de transfert ET1, ET2 comme dans l'art antérieur, du fait qu'avec l'invention, un même pixel peut comporter plusieurs étages consécutifs ; par suite les zones 14, qui constituent des doses spécifiques au fonctionnement en mode MPP sont réalisées seulement sous les deux électrodes qui délimitent le pixel.

La figure 3a illustre des profils de potentiels établis dans la structure de la figure 3 durant la période d'intégration de charges TI, conformément à l'habitude en matière de dispositif à transfert de charges, les potentiels positifs vont en croissant vers le bas. Les figures 3b et 3c illustrent des profils de potentiel établis dans la structure de la figure 3 dans une phase de transfert de charges.

Les puits de potentiel de stockage PI1 à PI3 représentés à la figure 3a sont ceux qui existent sous chaque pixel durant la période d'intégration TI, période durant laquelle les surfaces élémentaires photosensibles Z1 à Z3 sont éclairées. Dans le détecteur d'images conforme à l'invention, les charges engendrées par l'éclairement de la zone élémentaire photosensible Z1 à Z3 de chaque pixel PX1 à PX3, sont stockées dans le puits de potentiel PI1 à PI3 de ce même pixel jusqu'à la fin de la période d'intégration TI ; le puits de potentiel dans lequel sont stockées les charges étant de dimension plus grande que la zone élémentaire photosensible Z1 à Z3 qui a produit ces charges. Après la période d'intégration TI, une première, seconde et troisième quantités de charges Q1, Q2, Q3 sont respectivement stockées dans le premier, second et troisième puits de potentiel PI1, PI2, PI3 ; ces charges étant destinées à être transférées dans le sens de transfert montré par la flèche repérée ST.

Il est à noter que durant le transfert de ces quantités de charges Q1 à Q3, ces dernières sont divisées chacune en autant de parties ou paquets qu'il y a d'étages ET1, ET2 pour constituer un pixel, indépendamment du nombre de phases appliquées à chaque étage. Ainsi par exemple dans le cas représenté à la figure 3 où chaque pixel PX1 à PX3 est formé par deux étages ET1, ET2, chacune des quantités de charges Q1, Q2 et Q3 est divisée en deux parties A, B, comme représenté à la figure 3b, et ceci dès que les signaux de transfert ST1 à ST4 sont appliqués aux électrodes E1 à E4.

La figure 4 est un chronogramme qui montre la relation de phase entre les signaux de transfert ST1 à ST4 qui sont appliqués respectivement aux électrodes E1 à E4 de la figure 3. Les lignes a, b, c et d de la figure 4 montrent respectivement les signaux de transfert ST1, ST2, ST3, ST4.

Un instant t0 correspond au début de la période d'intégration TI. Pendant toute la durée du temps d'intégration TI, tous les signaux de transfert ST1 à ST4 sont à l'état bas ou état 0 qui par exemple, dans le cas d'un fonctionnement en mode MPP, correspond à une tension négative de l'ordre de moins 10 volts par rapport par une tension de référence VR ; la tension de référence VR étant la tension du substrat 11. Dans le cadre d'un fonctionnement en mode MPP, ceci permet d'inverser la polarité du canal enterré 12 montré à la figure 3.

Un instant t1 correspond à la fin de la période d'intégration TI et au début d'une phase de transfert des quantités de charges Q1, Q2, Q3 pour évacuer ces charges à l'extérieur de la zone photosensible. A l'instant t1 le premier et le second signal de transfert ST1, ST2 sont à l'état 0, alors que les troisième et quatrième signaux de transfert ST3, ST4 sont passés à l'état 1 qui, dans l'exemple non limitatif décrit, correspond sensiblement à un potentiel de 8 volts positifs par rapport à la tension de référence VR.

A l'instant t2, le premier signal de transfert ST1 passe à l'état 1 qui correspond à un potentiel de l'ordre de 8 volts par rapport à la tension de référence VR ; le second signal de transfert ST2 est à l'état 0, le troisième et quatrième signal de transfert ST3, ST4 sont à l'état 1.

A l'instant t3 : le premier signal de transfert ST1 est à l'état 1 ; le second signal de transfert ST2 est à l'état 0 ; le troisième signal de transfert ST3 passe de l'état 1 à l'état 0 ; le quatrième signal de transfert ST4 est à l'état 1.

A l'instant t4 : le premier signal de transfert ST1 est à l'état 1 ; le second signal de transfert ST2 passe de l'état 0 à l'état 1 ; le troisième signal de transfert est à l'état 0 ; le quatrième signal de transfert est à l'état 1.

A l'instant t5 : le premier et second signal de transfert ST1, ST2 sont à l'état 1 ; le troisième signal de transfert ST3 est à l'état 0 ; le quatrième signal de transfert ST4 passe de l'état 1 à l'état 0.

A l'instant t6 : le premier et second signal de transfert ST1, ST2 sont à l'état 1 ; le troisième signal de transfert ST3 passe de l'état 0 à l'état 1 ; le quatrième signal de transfert ST4 est à l'état 0.

A l'instant t7 : le premier signal de transfert ST1 passe de l'état 1 à l'état 0 ; le second et le troisième signal de transfert ST2, ST3 sont à l'état 1 ; le quatrième signal de transfert ST4 est à l'état 0.

A l'instant t8 : le premier signal de transfert ST1 est à l'état 0 ; le second et le troisième signal de transfert ST2, ST3 sont à l'état 1 ; le quatrième signal de transfert ST4 passe à l'état 1.

A l'instant t9 : le premier signal de transfert ST1 est à l'état 0 ; le second signal de transfert ST2 passe de l'état 1 à l'état 0 ; le troisième et le quatrième signal de transfert ST3, ST4 sont à l'état 1.

A l'instant t10 : le premier signal de transfert ST1 passe de l'état 0 à l'état 1 ; le second signal de transfert ST2 est à l'état 0 ; le troisième signal de transfert ST3 est à l'état 1 ; le quatrième signal de transfert ST4 est à l'état 1.

Ceci montre un cycle complet du premier signal de transfert par exemple dont le temps de cycle TC est compris entre l'instant t2 et l'instant t10 ; les quatre signaux de transfert étant des créneaux de tension cyclique ayant un même temps de cycle.

En référence à nouveau aux figures 3, 3a, 3b, 3c, l'application des signaux de transfert ST1, ST2, ST3, ST4 respectivement aux électrodes E1, E2, E3, E4, modifie les puits de potentiels qui existaient sous ces diverses électrodes durant la période d'intégration TI. En effet, à partir de l'instant t1 où ces signaux de transfert sont appliqués aux électrodes, chaque pixel PX1 à PX3 comprend deux puits de potentiels PIA, PIB (montrés à la figure 3b) contenant respectivement une quantité de charges QA et QB dont la somme constitue la quantité de charges Q1 à Q3 qui, jusqu'à la fin du temps d'intégration TI était stockée dans un unique puits de potentiel de stockage PI1, PI2, PI3 (montré à la figure 3a) ; dans l'exemple de la figure 3b, les puits de potentiels PIA, PIB sont formés, pour chaque pixel, sous les troisième et quatrième électrodes de chaque étage ET1, ET2.

La figure 3c illustre les profils de potentiels qui sont obtenus à l'instant t3 représenté à la figure 4. Par rapport à l'instant t1, le premier signal de transfert ST1 est à l'état 1 alors que le troisième signal de transfert ST3 est passé à l'état 0 : il en résulte que les puits de potentiels PIA, PIB se sont déplacés dans le sens de transfert ST et se trouvent situés sous les quatrième et première électrodes de chaque étage ET1, ET2.

Chaque modification de phase des signaux de transfert ST1 à ST4 entraîne ainsi un déplacement des charges QA, QB dans le sens de transfert, d'une manière qui en elle-même est classique.

Bien entendu le transfert de ces charges dans un registre de lecture doit permettre de retrouver toute la quantité de charges Q1, Q2, Q3 qui, initialement stockée dans un pixel dans un même puits de potentiel, a ensuite été éventuellement séparée en autant de paquets QA, QB qu'il y a d'étages ET1, ET2 pour constituer un pixel. Par exemple, lors du transfert dans un registre de lecture (non représenté), des charges QA, QB qui étaient initialement contenues dans le premier pixel PX1 par exemple, l'étage du registre de lecture qui aura reçu en premier la charge QA conservera la même position pour que des impulsions de transfert suivantes transfèrent la charge QB dans le même étage et réalisent la somme QA + QB pour obtenir la charge initiale Q1.

Cette nécessité d'effectuer le cumul de paquets de charges, en fonction du nombre d'étages que comporte un pixel, constitue une complexité supplémentaire négligeable au regard de l'augmentation considérable de la capacité de stockage de charges qui est obtenue.

## Revendications

1. Dispositif photosensible à transfert de charges, comportant :
- une pluralité de points photoensensibles ou pixels (PXl, PX2, PX3) disposés en lignes (L1, L2, L3, L4) et en colonnes (C1, C2, C3, C4),
- une mémoire (M) à transfert de charges, et
- un registre de lecture (RL) à transfert de charges,
chaque pixel comportant plusieurs électrodes (E1, E2, E3, E4) se succédant suivant un sens de transfert (ST) des charges dans le sens des colonnes de manière à constituer une succession d'étages de transfert (ET1, ET2),
une partie des électrodes de chaque pixel constituant une zone photosensible élémentaire sous laquelle est formé un puits de potentiel de stockage (PI1, PI2, PI3) destiné au stockage de charges engendrées par l'exposition de la zone photosensible élémentaire à un rayonnement utile pendant une période d'intégration,
la surface du puits de potentiel de stockage étant plus grande que la surface de la zone photosensible élémentaire,
les électrodes de chaque pixel constituant au moins deux étages de transfert sous lesquels est formé ledit puits de potentiel de stockage,
le puits de potentiel de stockage (PI1 à PI3) étant délimité suivant le sens de transfert (ST) entre uniquement deux barrières de potentiel indépendamment du nombre d'étages de transfert (ETI, ET2) que comporte le pixel (PX1 à PX3).

2. Dispositif photosensible selon revendication 1, le transfert des charges étant assuré à l'aide d'un canal enterré (12), caractérisé en ce que chaque puits de potentiel de stockage (PI1 à PI3) est délimité entre deux barrières de potentiel obtenues par différence de dopage (N-) dans le canal enterré (12).

3. Dispositif photosensible selon l'une des revendications précédentes, caractérisé en ce qu'il est du type à canal enterré (12) et en ce qu'il fonctionne suivant un mode dit "mode MPP" dans lequel on inverse la polarité du canal enterré (12) pendant l'exposition au rayonnement utile.

4. Dispositif photosensible selon l'une des revendications précédentes, caractérisé en ce qu'il comporte un écran (20) opaque au rayonnement utile, l'écran (20) étant interposé entre le rayonnement utile et au moins un pixel (PX1 à PX3), l'écran (20) comportant au moins une ouverture (21) dont la surface définit la surface de la zone photosensible élémentaire (Z1 à Z3) du pixel.

## Patentansprüche

1. Lichtempfindliche Vorrichtung mit Ladungsübertragung, die folgendes aufweist:
- eine Vielzahl von lichtempfindlichen Punkten oder Pixeln (PX1, PX2, PX3), die in Zeilen (L1, L2, L3, L4) und Spalten (C1, C2, C3, C4) angeordnet sind,
- einen Speicher (M) mit Ladungsübertragung sowie
- ein Leseregister (RL) mit Ladungsübertragung,
wobei jedes Pixel mehrere Elektroden (E1, E2, E3, E4) aufweist, die längs einer Übertragungsrichtung (ST) der Ladungen in Richtung der Spalten so aufeinanderfolgen, daß eine Aufeinanderfolge von Übertragungsstufen (ET1, ET2) gebildet ist,
wobei ein Teil der Elektroden jedes Pixels eine lichtempfindliche Elementzone bildet, unter der ein Speicherpotentialtopf (PI1, PI2, PI3) gebildet ist, der zum Speichern der Ladungen bestimmt ist, die dadurch erzeugt werden, daß die lichtempfindliche Elementzone einer Nutzstrahlung während einer Integrationsperiode ausgesetzt sind,
wobei die Oberfläche des Speicherpotentialtopfes größer als die Oberfläche der lichtempfindlichen Elementzone ist,
wobei die Elektroden jedes Pixels wenigstens zwei Übertragungsstufen bilden, unter denen der Speicherpotentialtopf gebildet ist,
wobei die Speicherpotentialtöpfe (PI1 bis PI3) in der Übertragungsrichtung (ST) unabhängig von der Anzahl von Übertragungsstufen (ET1, ET2), die das Pixel (PX1 bis PX3) aufweist, nur zwischen zwei Potentialbarrieren abgegrenzt sind.

2. Lichtempfindliche Vorrichtung nach Anspruch 1, worin die Übertragung der Ladungen mit Hilfe eines vergrabenen Kanals (12) gewährleistet ist, dadurch gekennzeichnet, daß jeder Speicherpotentialtopf (PI1 bis PI3) zwischen zwei Potentialbarrieren abgegrenzt ist, die durch einen Unterschied in der Dotierung (N-) in dem vergrabenen Kanal (12) erhalten sind.

3. Lichtempfindliche Vorrichtung nach einem der vorhergehenden Ansprüche, dadurch gekennzeichnet, daß sie von dem Typ mit vergrabenem Kanal (12) ist und nach einer Betriebsart arbeitet, die "MMP-Modus"genannt ist und bei der die Polarität des vergrabenen Kanals (12) während der Bestrahlung durch die Nutzstrahlung umgekehrt wird.

4. Lichtempfindliche Vorrichtung nach einem der vorhergehenden Ansprüche, dadurch gekennzeichnet, daß sie einen gegenüber der Nutzstrahlung undurchlässigen Schirm (20) aufweist, wobei der Schirm (20) zwischen die Nutzstrahlung und wenigstens ein Pixel (PX1 bis PX3) gesetzt ist, wobei der Schirm (20) wenigstens eine Öffnung (21) aufweist, deren Oberfläche die Oberfläche der lichtempfindlichen Elementzone (Z1 bis Z3) des Pixels begrenzt.

## Claims

1. Charge coupled photosensitive device including:
- a plurality of photosensitive points or pixels (PX1, PX2, PX3) arranged in rows (L1, L2, L3, L4) and colums (C1, C2, C3, C4),
- a charge coupled memory (M), and
- a charge coupled readout register (RL),
each pixel including several electrodes (E1, E2, E3, E4) following one another along a direction of transfer (ST) of charges in the direction of the columns so as to constitute a succession of transfer stages (ET1, ET2),
a portion of the electrodes of each pixel constituting an elementary photosensitive region under which is formed a storage potential well (PI1, PI2, PI3) intended for storing charges generated by exposing the elementary photosensitive region to useful radiation during an integration period,
the surface area of the storage potential well being greater than the surface area of the elementary photosensitive region,
the electrodes of each pixel constituting at least two transfer stages under which is formed the said storage potential well,
the storage potential well (PI1 to PI3) being delimited in the direction of transfer (ST) between just two potential barriers independently of the number of transfer stages (ET1, ET2) included in the pixel (PX1 to PX3).

2. Photosensitve device according to Claim 1, the transfer of the charges being accomplished with the aid of a buried channel (12), characterized in that each storage potential well (PI1 to PI3) is delimited between two potential barriers obtained through different doping (N-) in the buried channel (12).

3. Photosensitive device according to one of the preceding claims, characterized in that it is of the type with buried channel (12) and in that it operates in accordance with a mode termed "MPP mode" in which the polarity of the buried channel (12) is reversed during the exposure to the useful radiation.

4. Photosensitive device according to one of the preceding claims, characterized in that it includes a screen (20) which is opaque to the useful radiation, the screen (20) being interposed between the useful radiation and at least one pixel (PX1 to PX3), the screen (20) including at least one aperture (21), the area of which defines the surface area of the elementary photosensitive region (Z1 to Z3) of the pixel.
